Europäisches Patentamt

European Patent Office

Office européen des brevets

(19)

(11) **EP 1 541 709 A1**

(12) **DEMANDE DE BREVET EUROPEEN**

(43) Date de publication:
**15.06.2005 Bulletin 2005/24**

(51) Int Cl.⁷: **C23C 16/44**, H01L 21/00

(21) Numéro de dépôt: **04292907.5**

(22) Date de dépôt: **06.12.2004**

| | |
|---|---|
| (84) Etats contractants désignés:<br>**AT BE BG CH CY CZ DE DK EE ES FI FR GB GR HU IE IS IT LI LT LU MC NL PL PT RO SE SI SK TR**<br>Etats d'extension désignés:<br>**AL BA HR LV MK YU** | (72) Inventeurs:<br>• **Desbiolles, Jean-Pierre**<br>**74350 Cruseilles (FR)**<br>• **Parrochon, Johann**<br>**74940 Annecy Le Vieux (FR)** |
| (30) Priorité: **09.12.2003 FR 0314378** | (74) Mandataire: **Fournier, Michel Robert Marie**<br>**COMPAGNIE FINANCIERE ALCATEL**<br>**Département Propriété Industrielle**<br>**54, rue La Boétie**<br>**75008 Paris (FR)** |
| (71) Demandeur: **ALCATEL**<br>**75008 Paris (FR)** | |

(54) **Arrangement pour le contrôle du flux d'agents de nettoyage dans un dispositif de recirculation**

(57)      Selon l'invention, une chambre de procédés (1), ayant une canalisation de vide (4) avec un groupe de pompage principal (3), est associée à un dispositif de recirculation (9) qui prélève une partie des gaz en sortie de la chambre de procédés (1) pour les filtrer par un piège (11) et les réinjecter à une entrée (22) de la chambre de procédés (1). Le dispositif de recirculation (9) se caractérise par des moyens de capteur de pression (7, 14) pour mesurer le flux de recirculation sans introduire de pertes de charge, de sorte que la pression gazeuse reste basse dans le dispositif de recirculation (9). On garantit ainsi la sécurité de fonctionnement du dispositif, tout en améliorant sa capacité de recirculation.

FIG. 1

**Description**

La présente invention concerne les moyens pour commander le flux d'agents de nettoyage dans une chambre de procédés, au cours des étapes de nettoyage des chambres.

Lors de la fabrication des composants de microélectrique ou des microsystèmes électromécaniques (MEMS), on traite des plaquettes de semi-conducteurs dans des chambres de procédés contenant une atmosphère gazeuse à faible pression. Certaines étapes des procédés utilisent, dans les chambres de procédés, des plasmas de gaz de dépôt, qui réalisent des dépôts sur les plaquettes de semi-conducteurs en cours de traitement. Mais ces dépôts s'effectuent également sur les parois des chambres de procédés.

On doit donc périodiquement nettoyer les chambres de procédés au moyen d'agents de nettoyage gazeux appropriés sous une atmosphère contrôlée, généralement à faible pression.

Pour assurer une action satisfaisante des agents de nettoyage gazeux, il est nécessaire d'en contrôler le flux, tout en maintenant une pression gazeuse appropriée dans la chambre de procédés.

Pour maintenir cette pression gazeuse appropriée, les chambres de procédés sont généralement raccordées à une ligne de vide comportant une ou plusieurs pompes à vide qui prélèvent les gaz de la chambre de procédés et les évacuent vers l'atmosphère. La ligne de vide comporte habituellement une vanne de commande en sortie de chambre de procédés, pour contrôler la pression gazeuse à l'intérieur de la chambre de procédés.

Lors des étapes de nettoyage des chambres de procédés dans lesquelles on veut supprimer les dépôts d'oxyde de silicium résultant des procédés précédents (par exemple SACVD, PECVD, HDPCVD), on utilise un gaz de nettoyage qui est craqué par plasma soit directement dans la chambre de procédés, soit dans une chambre annexe qui communique avec la chambre de procédés. Dans tous les cas, le craquage par plasma nécessite, dans la chambre de procédés, une atmosphère à faible pression.

On contrôle jusqu'à présent le flux de gaz de nettoyage dans la chambre de procédés en pilotant l'injection de gaz de nettoyage dans la chambre de procédés.

On comprend que le maintien d'une pression faible dans la chambre de procédés nécessite une évacuation permanente des gaz par la ligne de vide. Il en résulte une évacuation permanente des gaz de nettoyage, et une grande consommation de gaz de nettoyage qui est un agent onéreux et polluant.

Par exemple, lors d'un nettoyage de l'oxyde de silicium par le trifluorure d'azote (NF$_3$), le fluor atomique dissocié dans le plasma se combine à l'oxyde de silicium par la réaction :

$$4F + SiO_2 \rightarrow SiF_4 + O_2$$

Après le craquage du trifluorure d'azote par le plasma, une grande partie des atomes de fluor ne réagissent pas avec l'oxyde de silicium et se recombinent en molécules de fluor F$_2$. Ainsi, lors d'une étape de nettoyage, une grosse partie du potentiel nettoyant du gaz de nettoyage se trouve inutilisée, et rejetée dans l'atmosphère.

Pour éviter cette perte, on a déjà proposé dans le document US 2003/036272 A1 plusieurs solutions dont le principe est de prélever le mélange gazeux en sortie de la chambre de procédés, de filtrer ce mélange pour en extraire les produits résultant du nettoyage, puis de réinjecter le mélange filtré dans la source de plasma en addition d'un flux de gaz de nettoyage injecté dans la source de plasma. Le document mentionne la nécessité de connaître et de contrôler le flux de recirculation, et propose pour cela de placer un contrôleur de flux (MFC) en série dans la ligne de recirculation. Du fait de la présence de ce contrôleur de flux, il se produit dans la ligne de recirculation une pression de plus de 100 Torr qui est nécessaire, selon ce document, pour extraire des produits résultant du nettoyage, comme de tétrafluorure de silicium (SiF$_4$).

Parmi les moyens proposés pour extraire les produits résultant du nettoyage, dans la ligne de recirculation, le document propose de recourir à un piégeage cryogénique, et de régénérer périodiquement le piège cryogénique pour évacuer les produits qu'il condense. Le document propose alors soit de pomper la ligne de recirculation à travers la chambre de procédés après l'étape de nettoyage, soit d'évacuer pendant cette étape de nettoyage les produits de nettoyage sous forme liquide, ce qui requiert une pression de l'ordre de 100 à 600 Torr.

La solution de recirculation proposée dans le document n'est pas satisfaisante, pour plusieurs raisons.

Tout d'abord, on a pu constater des défauts graves de fonctionnement dans certaines conditions d'utilisation, par suite d'une corrosion des pompes.

Ensuite, la régénération du piège cryogénique à travers la chambre de procédés peut polluer la chambre de procédés elle-même, ce qui est le contraire du but recherché. Egalement, l'étape de régénération rend la chambre de procédés indisponible pendant une période non négligeable, ce qui réduit le rendement global de l'installation.

Le problème proposé par la présente invention est de concevoir une nouvelle structure de moyens pour la génération et la commande du flux d'agents de nettoyage dans une chambre de procédés, qui présente une sécurité de fonctionnement satisfaisante, sans risque de corrosion.

L'invention vise simultanément à améliorer la capacité de recirculation du système, en évitant notamment que la régénération du piège cryogénique perturbe le fonctionnement de la chambre de procédés.

Pour cela, l'invention résulte en effet de l'observation surprenante selon laquelle les défauts de fonctionnement des dispositifs connus seraient apparemment dus à une pression gazeuse trop importante dans certaines portions de la ligne de recirculation, et l'abaissement de cette pression permet de réduire sensiblement les risques de corrosion et d'anomalie de fonctionnement.

Ainsi, pour atteindre ces buts ainsi que d'autres, l'invention propose un dispositif pour la génération et la commande du flux d'agents de nettoyage, adaptable sur une chambre de procédés pour assurer son nettoyage par un agent de nettoyage gazeux, comprenant un dispositif de recirculation adapté pour prélever des gaz sortant de la chambre de procédés et pour les filtrer et les réintroduire dans la chambre de procédés ; le dispositif de recirculation est structuré de façon que, en toutes portions de son trajet dans le dispositif de recirculation, les gaz recyclés restent sensiblement à la pression basse régnant dans la chambre de procédé. Ce qui signifie que les gaz recyclés restent à une pression inférieure à quelques Torr (quelques dizaines de Pascals), avantageusement inférieure à 20 Torr environ (260 Pascals environ).

Selon un mode de réalisation pratique, le dispositif pour la génération et la commande du flux d'agents de nettoyage comprend :

- une canalisation de recirculation dans laquelle est insérée une pompe de recirculation multiétagée,
- une aspiration de pompe de recirculation reliée à la chambre de procédé,
- une sortie dérivée au refoulement du premier étage de la pompe, la sortie dérivée étant connectée à la canalisation de recirculation,
- une canalisation de retour connectée entre le refoulement du dernier étage de la pompe de recirculation et la sortie dérivée,
- une canalisation de refoulement raccordée entre le refoulement du dernier étage de la pompe de recirculation et le refoulement du groupe de pompage principal de la chambre de procédés.

Le dispositif comprenant en outre des vannes tout ou rien, pilotées par un dispositif de commande pour isoler le dispositif de recirculation par rapport à la chambre de procédés pendant les étapes de régénération du piège.

Selon un autre mode de réalisation pratique, le dispositif pour la génération et la commande du flux d'agents de nettoyage comprend un dispositif de recirculation comportant une canalisation de recirculation dans laquelle sont insérés une pompe de recirculation, un piège pour retenir sélectivement les produits issus du nettoyage de la chambre de procédés, et un moyen de mesure de flux pour mesurer le flux gazeux de recirculation en aval du piège ; la pompe de recirculation est entraînée par un moteur à vitesse variable ; un contrôleur de commande pilote la vitesse du moteur d'entraînement de pompe de recirculation ; le moyen de mesure de flux comprend un second capteur de pression adapté dans une zone de la canalisation de recirculation en aval du piège, et un premier capteur de pression adapté en aval du second capteur de pression dans la canalisation de recirculation ou dans la chambre de procédés ; un contrôleur de flux reçoit les informations du premier et du second capteurs de pression et contient un programme enregistré et des données de comparaison enregistrées pour déterminer le flux de recirculation à partir desdites informations du premier et du second capteurs de recirculation.

La présence des capteurs de pression dans la canalisation de recirculation n'induit aucune perte de charge, de sorte que les gaz peuvent s'écouler librement dans la canalisation de recirculation. Le piège cryogénique n'introduit, lui non plus, pas de perte de charge sensible. Ainsi, le dispositif de recirculation ne comporte aucune zone de surpression gazeuse.

Les données de comparaison enregistrées sont normalement spécifiques de la conductance du système de recirculation et de la façon dont est relié le système de recirculation au système client. Selon l'invention, on peut donc avantageusement prévoir que le programme enregistré contient une séquence d'apprentissage par laquelle le contrôleur de flux enregistre deux suites de mesures de pression réalisées respectivement par le premier capteur de pression et par le second capteur de pression pour une série de valeurs connues de flux de gaz parcourant le dispositif de recirculation.

En alternative ou en complément, on peut prévoir que le contrôleur de commande pilote la vitesse du moteur d'entraînement de la pompe de recirculation de façon à établir un flux de recirculation selon une courbe de valeurs de flux prédéterminées.

Dans ce cas, on peut prévoir que le contrôleur de commande qui pilote la pompe de recirculation est également le contrôleur de flux du moyen de mesure de flux. Ce contrôleur combiné reçoit une consigne évolutive en forme de courbe de valeurs de flux et pilote le moteur de la pompe de recirculation de façon que les valeurs mesurées de flux de recirculation suivent la consigne évolutive.

En alternative, le contrôleur de commande qui pilote la pompe de recirculation peut recevoir une consigne évolutive de flux de recirculation, qu'il traduit par un programme en termes de vitesse de la pompe de recirculation pour piloter la vitesse du moteur d'entraînement de la pompe de recirculation.

Dans ce cas, le programme du contrôleur de commande de pompe de recirculation peut contenir une séquence d'apprentissage qui commande la rotation du moteur d'entraînement de pompe de recirculation selon une suite de vitesses de rotation, et qui enregistre les valeurs mesurées du flux de recirculation correspondant provenant du contrôleur de flux ou des capteurs de pression, pour définir la relation entre la vitesse de rotation de la pompe de recirculation et la valeur du flux de recirculation.

Selon une autre alternative, le contrôleur de commande de pompe de recirculation peut contenir une séquence de programme enregistrée qui détermine la valeur nécessaire du flux de recirculation pour maintenir constant le flux total d'agents de nettoyage dans la chambre de procédés lorsque varie le flux d'agents de nettoyage injecté directement dans la chambre de procédés.

Selon un mode de réalisation avantageux de l'invention, qui améliore la capacité de recirculation, le dispositif comprend un piège cryogénique disposé en amont de la pompe de recirculation.

De préférence, on prévoit des vannes tout ou rien, pilotées par un dispositif de commande, pour isoler le dispositif de recirculation par rapport à la chambre de procédés pendant les étapes de régénération du piège cryogénique.

On évite ainsi de faire traverser la chambre de procédés par les gaz issus du processus de régénération du piège cryogénique.

L'invention a aussi pour objet un procédé de nettoyage par un agent de nettoyage gazeux d'une chambre de procédé associée à une source plasma au moyen du dispositif pour la génération et la commande du flux d'agents de nettoyage décrit précédemment, comprenant une étape d'utilisation de la chambre de procédé, une étape de nettoyage de la chambre de procédé, et une étape de régénération du dispositif. Selon ce procédé, l'étape de régénération peut être effectuée simultanément à l'étape d'utilisation. Ainsi l'étape de régénération peut avoir lieu pendant chaque étape d'utilisation. La régénération est plus facile à mettre en oeuvre et peut ainsi être aussi fréquente que les étapes du procédé autres que celles de nettoyage. Les dépôts accumulés dans le piège cryogénique sont ainsi en faible quantité.

Au cours de l'étape de nettoyage, une partie minoritaire des gaz recyclés remonte tous les étage de la pompe, sort par la canalisation de retour et rejoint la sortie dérivée, et la majorité des gaz recyclés passe directement par la sortie dérivée.

Au cours de l'étape de régénération, la vanne est ouverte et la pompe vide le système de recirculation en extrayant les produits issus du nettoyage condensés sur le piège cryogénique et en les refoulant dans la canalisation.

D'autres objets, caractéristiques et avantages de la présente invention ressortiront de la description suivante de modes de réalisation préférés faite en relation avec les figures annexées, dans lesquelles :

- la figure 1 représente schématiquement la structure des moyens de génération et de commande du flux d'agents de nettoyage dans une chambre de procédés ; et
- la figure 2 est une vue schématique en coupe d'un piège cryogénique adapté à la présente invention.

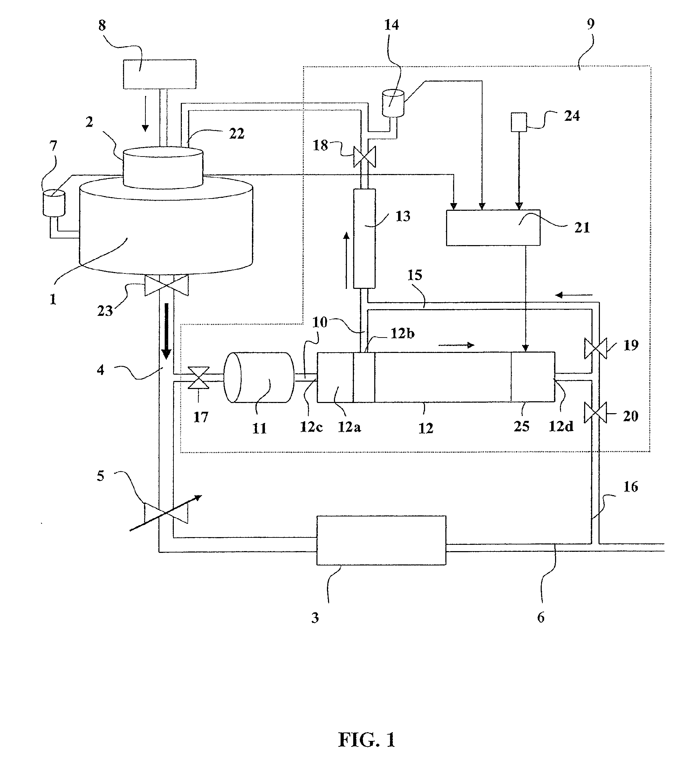

Dans le mode de réalisation illustré sur la figure 1, une chambre de procédés 1 est associée à une source de plasma 2 qui génère un plasma dans la chambre de procédés 1 en fonction des étapes du procédé. Une ligne de vide, raccordée à la chambre de procédés 1, comprend un groupe de pompage principal 3 relié à une sortie de la chambre de procédés 1 par une canalisation de vide 4 et une vanne de commande 5 à ouverture variable. Le groupe de pompage principal 3 refoule à l'atmosphère par une canalisation de sortie 6.

La pression dans la chambre de procédés 1 est mesurée par un premier capteur de pression 7 qui envoie les signaux de pression à un dispositif de commande 21 qui lui-même pilote la vanne de commande 5 pour commander la pression dans la chambre de procédés 1.

En alternative, la vanne de commande 5 peut être absente si la pression dans la chambre de procédés 1 est commandée par variation de la vitesse de pompage dans le groupe de pompage principal 3.

Une source de gaz de nettoyage 8 est adaptée pour injecter, dans la source de plasma 2, un flux approprié de gaz de nettoyage pendant les étapes de nettoyage de la chambre de procédés.

Dans la source de plasma 2, le gaz de nettoyage est craqué afin de libérer les atomes actifs qui sont les agents de nettoyage. Les atomes actifs réagissent sur les dépôts solides présents sur les parois de la chambre de procédés 1, afin de produire des composés gazeux qui sont éliminés par pompage au moyen du groupe de pompage principal 3.

Le dispositif selon l'invention comprend un système de recirculation 9, entouré en pointillés sur la figure.

Le système de recirculation 9 comprend une canalisation de recirculation 10 raccordée d'une part à la canalisation de vide 4 en sortie de la chambre de procédés 1, et d'autre part à une entrée 22 de la chambre de procédés 1.

Dans la canalisation de recirculation 10, se trouvent successivement un piège 11, avantageusement un piège cryogénique, puis une pompe de recirculation 12 entraînée en rotation par un moteur 25, puis éventuellement un filtre 13, ensuite un second capteur de pression 14 adapté pour mesurer la pression gazeuse à l'intérieur de la canalisation

**EP 1 541 709 A1**

de recirculation 10 en aval de la pompe de recirculation 12 ou en aval du filtre 13 lorsque celui-ci est présent, mais à l'écart de l'entrée 22 dans la chambre de procédés 1.

Les capteurs de pression 7 et 14 sont des jauges adaptées aux mesures de pression dans la gamme des pressions de fonctionnement régnant dans la canalisation de recirculation 10. On pourra par exemple utiliser des jauges de la gamme "Baratron" proposées par la société MKS Instruments, USA.

La pompe de recirculation 12 est une pompe multiétagée, avec un premier étage 12a dont l'aspiration est connectée en sortie du piège 11 et comportant, à son refoulement, une sortie dérivée 12b. La ligne de recirculation 10 traverse le premier étage 12a de la pompe de recirculation 12, entre l'aspiration 12c et la sortie dérivée 12b.

Au refoulement 12d du dernier étage de la pompe de recirculation 12, on raccorde une canalisation de retour 15 qui retourne à la sortie dérivée 12b, et on raccorde une canalisation de refoulement 16 qui se raccorde elle-même à la canalisation de sortie 6 de la ligne de vide, c'est-à-dire au refoulement du groupe de pompage principal 3 de la chambre de procédés 1.

Une vanne tout ou rien 17 est disposée sur la canalisation de recirculation 10 avant le piège 11. Une autre vanne tout ou rien 18 est disposée dans la canalisation de recirculation 10 en aval du filtre 13. La vanne tout ou rien 18 peut être en amont ou en aval du second capteur de pression 14. Une autre vanne tout ou rien 19 est disposée sur la canalisation de retour 15, et une quatrième vanne tout ou rien 20 est disposée sur la canalisation de refoulement 16.

Le dispositif de commande 21 gère les vannes tout ou rien 17, 18, 19 et 20 en fonction des étapes du procédé de nettoyage, et pilote également la vitesse du moteur 25 d'entraînement de la pompe de recirculation 12, en fonction de signaux de pression reçus du premier capteur de pression 7, de signaux de pression reçus du second capteur de pression 14, et d'une consigne de flux 24.

Pour cela, le dispositif de commande 21 contient des données enregistrées en mémoire, et un programme approprié, pour piloter les différents organes du dispositif de génération et de commande de flux d'agents de nettoyage afin d'obtenir, dans la chambre de procédés 1, un flux satisfaisant de gaz de nettoyage.

Les données enregistrées dans le dispositif de commande 21 comprennent tout d'abord des données de comparaison enregistrées qui permettent de déterminer le flux de recirculation dans la canalisation de recirculation 10 en fonction des informations données par le premier capteur de pression 7 et le second capteur de pression 14.

Ces données de comparaison sont recueillies au cours d'une procédure préalable d'apprentissage de la canalisation de recirculation 10. Pour cela, on injecte un flux connu d'un gaz quelconque depuis la source de gaz de nettoyage 8, et on fait fonctionner la pompe de recirculation 12 en sens inverse, pour que le gaz injecté circule depuis la sortie du système de recirculation 9 jusqu'à son entrée, passant ainsi tout d'abord par le filtre 13 puis par la pompe de recirculation 12 et par le piège 11, pour être finalement évacué par le groupe de pompage principal 3. Les vannes tout ou rien 17, 18 et 19 sont ouvertes, tandis que la vanne tout ou rien 20 est fermée. Pendant cette étape d'apprentissage de la canalisation, la chambre de procédés 1 est isolée par une vanne d'isolation 23 en position fermée. Un algorithme contenu dans le programme du dispositif de commande 21 enregistre alors, pour plusieurs valeurs de flux, la différence entre les pressions indiquées par les deux capteurs de pression 7 et 14. Le premier capteur de pression 7 donne la pression à l'entrée 22 de la chambre de procédés 1, et le second capteur de pression 14 donne la pression au second point de mesure dans la ligne de recirculation 10. Le résultat est une courbe représentant la différence des pressions en fonction du flux circulant dans cette partie de la ligne de recirculation 10, c'est-à-dire entre l'entrée 22 et le second capteur de pression 14.

Dans un second temps on recherche les propriétés de la pompe de recirculation 12, par une seconde étape d'apprentissage.

Au cours de cette seconde étape, on injecte un flux d'un gaz quelconque depuis la source de gaz 8 et on fait fonctionner la pompe de recirculation 12 en sens direct, pour faire recirculer les gaz dans la canalisation de recirculation 10 depuis le piège 11 vers le second capteur de pression 14. La vanne d'isolation 23 est ouverte, ainsi que les vannes tout ou rien 17, 18 et 19. La vanne tout ou rien 20 est fermée. La pression dans la chambre de procédés 1 est régulée par la vanne de commande 5, aux valeurs habituelles correspondant à l'étape de nettoyage de la chambre de procédés 1. On relève alors, pour plusieurs valeurs de vitesse d'entraînement de la pompe de recirculation 12, la valeur du flux circulant entre le second capteur de pression 14 et l'entrée 22 dans la chambre de procédés 1, grâce à l'étalonnage précédent de la canalisation de recirculation 10. Le résultat est une courbe représentant le flux recirculant dans le système de recirculation 9 en fonction de la vitesse d'entraînement de la pompe de recirculation 12.

On notera que le premier capteur de pression 7 doit être positionné, dans la chambre de procédés 1, de façon à capter la pression à l'entrée 22 de la chambre de procédés 1.

Grâce à cette structure de système de recirculation 9, dépourvue d'appareil de mesure de débit qui introduit une surpression, le flux gazeux circulant dans la canalisation de recirculation 10 est en tout point sensiblement à la pression basse régnant dans la chambre de procédés 1. Ainsi, on maintient les gaz corrosifs tels que le fluor à pression basse, inférieure ou égale à 20 Torr, ce qui garantit la sécurité.

Lorsque les données obtenues par les étapes d'apprentissage précédentes sont enregistrées dans le dispositif de commande 21, l'ensemble peut assurer le contrôle d'une étape de nettoyage de la chambre de procédés 1. La vanne 23 est alors ouverte, la pression dans la chambre de procédés 1 est régulée par la vanne de commande 5 ou par variation de la vitesse de pompage du groupe de pompage principal 3. Un flux de gaz de nettoyage est injecté depuis la source de gaz de nettoyage 8, mais ce flux est inférieur au flux standard nécessaire pour une étape de nettoyage correcte habituelle.

La différence entre le flux standard et le flux réellement injecté est une quantité déterminée par les limites de capacité de recirculation du système de recirculation 9. Cette différence correspond à l'économie réalisée de gaz de nettoyage.

Pour assurer la recirculation du gaz de nettoyage, les vannes 17, 18 et 19 sont ouvertes, et la vanne 20 est fermée. La pompe de recirculation 12 fonctionne en sens direct afin d'extraire les gaz depuis la canalisation de vide 4 et de les réinjecter dans la source de plasma 2 par l'entrée 22.

Une partie minoritaire du gaz recirculant remonte tous les étages de la pompe de recirculation 12, alors que la majorité passe directement par la sortie dérivée 12b. La canalisation de retour 15 permet au gaz qui remonte tous les étages de la pompe de recirculation 12 de rejoindre la canalisation de recirculation 10. Ainsi, il n'y a pas de compression ni d'échauffement de gaz de nettoyage corrosif à l'intérieur de la pompe de recirculation 12, ce qui est une garantie de sécurité.

Pour le reste, l'étape de nettoyage reprend les procédures connues des nettoyages de chambre de procédés 1 par mélange de gaz de recirculation et de gaz injecté, comme décrit dans le document US 2003/036272 A1.

Le piège 11 doit être d'un type qui n'augmente pas localement la pression du gaz de nettoyage dans la canalisation de recirculation 10, pour optimiser la sécurité du système.

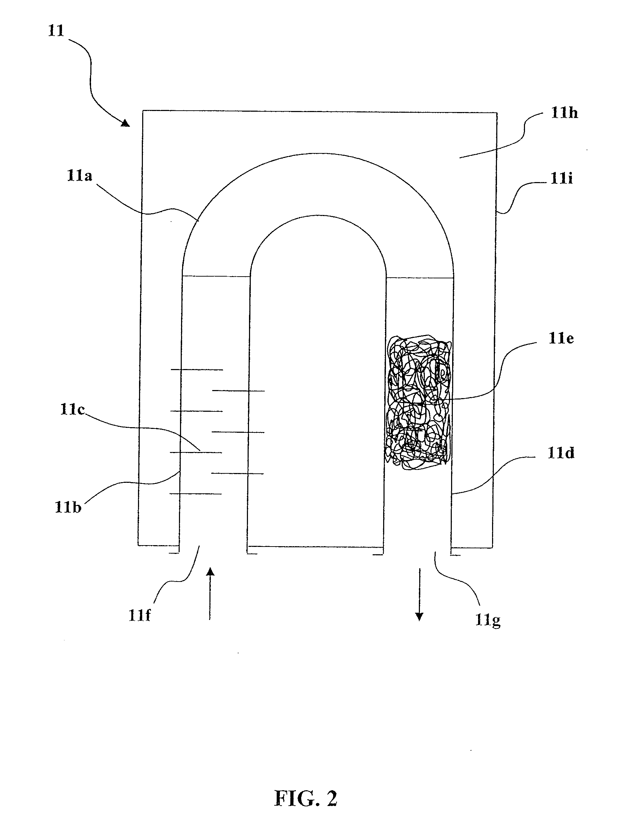

On peut avantageusement utiliser un piège 11 de type piège cryogénique, en prenant soin que le piège cryogénique offre un maximum de surface d'échange entre le froid et le gaz, sans pour autant gêner le passage du gaz. On peut par exemple, comme illustré sur la figure 2, utiliser une canalisation 11a conductrice de la chaleur, ayant un tronçon amont 11b dont la paroi est traversée par des ailettes 11 c conductrices de la chaleur, ayant un tronçon aval 11 d rempli de mailles 11 e en acier inoxydable au contact de la paroi de canalisation. La canalisation 11a est traversée par le flux de recirculation, qui pénètre par son entrée amont 11f et sort par sa sortie aval 11g. Entre l'entrée 11f et la sortie 11g, la canalisation 11a est baignée extérieurement dans de l'azote liquide 11 h contenu dans un caisson 11 i.

De façon avantageuse, le piège cryogénique 11 est disposé en amont de la pompe de recirculation 12. Cette disposition permet d'envoyer un gaz froid, donc moins dangereux, dans la pompe de recirculation 12.

Pendant l'étape de nettoyage, les produits de nettoyage tels que $SiF_4$ se condensent sur les surfaces froides du piège. Lorsque l'étape de nettoyage est terminée, on ferme les vannes 17, 18 et 19 pour isoler la chambre de procédés 1 du système de recirculation 9, et une autre étape de procédé peut être effectuée dans la chambre de procédés 1, indépendamment de ce qui se passe dans le système de recirculation 9.

Pendant cette autre étape de procédé, la vanne 20 est ouverte et la pompe de recirculation 12 fonctionne en sens direct pour vider le système de recirculation 9 en extrayant les produits de nettoyage condensés sur le piège cryogénique 11 et en les refoulant dans la canalisation de refoulement 16.

Une purge d'azote peut être ouverte en amont du piège cryogénique pour faire monter la pression et la température à l'intérieur du piège cryogénique 11, faisant circuler un flux de gaz chaud qui contribue à la sublimation du dépôt de produits de nettoyage dans le piège cryogénique 11.

On peut prévoir une résistance chauffante à l'intérieur du piège cryogénique 11, alimentée pour réchauffer le piège cryogénique 11 et ainsi contribuer encore à la sublimation du dépôt de produits de nettoyage.

Ainsi, la régénération du piège est réalisée en temps masqué, pendant que d'autres étapes de procédé sont effectuées, et sans que les produits évacués lors de cette régénération ne repassent par la chambre de procédés 1 ni par la canalisation de vide 4. La régénération est plus facile à mettre en oeuvre et peut ainsi être aussi fréquente que les étapes du procédé autres que celles de nettoyage. Les dépôts accumulés dans le piège cryogénique sont ainsi en faible quantité, ce qui est une autre garantie de sécurité pour le cas où le dépôt se sublimerait accidentellement de façon brusque.

Il est également possible de régénérer le piège 11 pendant une étape de nettoyage de la chambre de procédés, à condition d'effectuer cette procédure de nettoyage sans recirculation.

Le dispositif selon l'invention vise également à établir et contrôler le flux d'agents de nettoyage global présent dans la chambre de procédés 1 pendant une étape de nettoyage.

Selon l'invention, le contrôleur de pompe de recirculation contient une séquence de programme enregistrée qui détermine la valeur nécessaire du flux de recirculation pour maintenir constant le flux total d'agents de nettoyage dans la chambre de procédés lorsque varie le flux d'agents de nettoyage injecté directement dans la chambre de procédés 1.

A cet égard, la pompe de recirculation 12 doit provoquer la recirculation non seulement du gaz actif de nettoyage, mais également des produits gazeux résultant du craquage par plasma et de la décomposition des dépôts solides à supprimer de la chambre de procédés 1 et qui ne sont pas piégés dans le piège 11.

La détermination du flux nécessaire doit donc être effectuée en tenant compte de ce mélange, et un exemple est donné ci-après.

On connaît le flux de gaz dans la canalisation de recirculation 10. Le but du programme expliqué dans ces lignes est de calculer le flux de recirculation nécessaire pour que le flux d'atomes de fluor dans la chambre de procédés 1 soit le même que dans le cas du nettoyage standard, c'est-à-dire sans recirculation.

Il faut pour cela déterminer la part de fluor moléculaire dans ce flux de recirculation. Nous affirmons que la part de fluor atomique dans ce flux est minime, tant le processus de recombinaison $F + F \rightarrow F_2$ est avancé.

Il faut aussi connaître la proportion de fluor utilisée pour nettoyer la chambre de procédés selon

$$4 F + SiO_2 \rightarrow SiF_4 + O_2$$

Le chiffre de 13% de fluor utilisé est un exemple réaliste pour un procédé de dépôt PECVD.

Il faut enfin connaître le flux de gaz de nettoyage injecté dans le cas du nettoyage standard. Prenons l'exemple existant de 1500 sccm de $NF_3$. Si on suppose que les 1500 sccm sont entièrement dissociés dans la source de plasma, on peut en déduire un flux théorique de 4500 sccm d'atomes de fluor. Si 13% d'entre eux réagissent avec du silicium déposé sur les parois de la chambre de procédés, et 87% se recombinent en molécules $F_2$, cela implique des flux en sortie de chambre de 1958 sccm de $F_2$ et 146 sccm de $SiF_4$.

Pour que le nettoyage de la chambre soit aussi efficace que dans le cas standard, il faut donc que le flux de $SiF_4$ en sortie de chambre soit de 146 sccm, ce qui implique que le flux de $F_2$ y soit de 1958 sccm, étant donné l'équilibre entre la réaction de recombinaison du fluor et celle d'attaque du silicium déposé sur les parois.

Si on décide d'économiser les deux tiers du $NF_3$ injecté dans le cas standard, on injectera seulement 500 sccm de $NF_3$ au lieu de 1500 sccm. Cela signifie un flux théorique de 1500 sccm d'atomes de fluor au lieu de 4500. Il en résulte un manque de 3000 sccm d'atomes de fluor. Ces 3000 sccm seront assurés par la recirculation, qui devra donc contenir un flux de 1500 sccm de $F_2$.

Comme le flux de $F_2$ en sortie de la chambre de procédés 1 doit être égal à 1958 sccm, et que le flux de $F_2$ recirculant vaut 1500 sccm, le flux de $F_2$ pompé par le pompage principal et évacué vaut 458 sccm.

On fait ensuite l'hypothèse que le pompage principal évacue les gaz indépendamment de leur nature. Les proportions des gaz à l'entrée du pompage principal seront donc les mêmes que celles en sortie de la chambre de procédés. Et ces proportions de gaz correspondent aux proportions des flux.

On a donc la relation suivante pour l'évacuation (1), valable pour les quatre espèces $N_2$, $O_2$, $F_2$ et $SiF_4$ : on note

fl.ev = flux évacué
fl.sor = flux en sortie de chambre
fl.rec = flux recirculant

$$\text{fl.ev de } F_2 \text{ / fl.ev total} = \text{fl.sor de } F_2 \text{ / fl.sor total} \qquad (1)$$

Et il en découle que

$$\text{fl.ev de } SiF_4 = \text{fl.ev de } F_2 \text{ / fl.sor de } F_2 \text{ * fl.sor de } SiF_4$$
$$= 458 / 1958 * 146$$
$$= 34 \text{ sccm}$$

Connaissant fl.ev de $SiF_4$ et fl.sor de $SiF_4$, on en déduit : flux piégé de $SiF_4$ = 112 sccm

Or la pompe évacue ce qui tend à faire augmenter la pression dans le système, d'où

fl.ev total = bilan des réactions du $NF_3$ injecté + bilan des réactions du $F_2$ recyclé - flux piégé

Bilan des réactions du $NF_3$ injecté (500 sccm):

250 sccm de $N_2$

$$0,87*1500/2 = 652 \text{ sccm de } F_2$$

$$0,13*1500/4 = 49 \text{ sccm de SiF}_4$$

$$0,13*1500/4 = 49 \text{ sccm de O}_2$$

Le bilan vaut 1000 sccm de gaz en plus.

+ bilan des réactions du $F_2$ recyclé (1500 sccm):

$$0,87*3000/2 = 1305 \text{ sccm de F}_2$$

$$0,13*3000/4 = 98 \text{ sccm de SiF}_4$$

$$0,13*3000/4 = 98 \text{ sccm de O}_2$$

Le bilan est nul en terme de quantité de gaz.
- flux piégé (112 sccm)

D'où fl.ev total = 1000 - 112 = 888 sccm

On cherche ensuite à déterminer les flux de $O_2$ et de $N_2$.

On a pour $O_2$ les deux relations suivantes :

$$\text{fl.sor de } O_2 = \text{fl.rec de } O_2 + \text{flux de } O_2 \text{ créé dans la chambre} \qquad (2)$$

$$\text{fl.sor de } O_2 = \text{fl.rec de } O_2 + \text{fl.ev de } O_2 \qquad (2\text{bis})$$

On a pour $N_2$ les deux relations suivantes :

$$\text{fl.sor de } N_2 = \text{fl.rec de } N_2 + (\text{injection de } NF_3) / 2 \qquad (3)$$

$$\text{fl.sor de } N_2 = \text{fl.rec de } N_2 + \text{fl.ev de } N_2 \qquad (3\text{bis})$$

On en déduit fl.ev de $O_2$ et fl.ev de $N_2$, puis avec la relation (1) viennent fl.sor de $N_2$ et fl.sor de $O_2$, et enfin fl.rec de $N_2$ et fl.rec de $O_2$ en écrivant dans les relations (2) et (3) les valeurs calculées de fl.sor de $N_2$ et fl.sor de $O_2$.

Ce modèle repose sur l'hypothèse que même si le flux total passant dans la chambre est différent du flux habituel, la réactivité des atomes de fluor vis à vis du silicium restera la même (13%).

Exemple : en appliquant ces dernières relations, on obtient tous les flux (en sccm)

|         | Sortie de chambre | évacuation | recirculation |
|---------|-------------------|------------|---------------|
| $F_2$   | 1958              | 458        | 1500          |
| $O_2$   | 626               | 147        | 479           |
| $N_2$   | 1072              | 250        | 822           |
| $SiF_4$ | 146               | 34         | 112*(piégé)   |
| Total   | 3802              | 888        | 2801          |

Le flux de recirculation est de 2800 sccm si on décide d'économiser les deux tiers de l'injection standard de $NF_3$.

Les équations ci-dessus sont utilisables pour déterminer chacun des points de la courbe de variation nécessaire du flux de recirculation pour obtenir le flux désiré de produits de nettoyage dans la chambre de procédés 1.

La présente invention n'est pas limitée aux modes de réalisation qui ont été explicitement décrits, mais elle en inclut les diverses variantes et généralisations qui sont à la portée de l'homme du métier.

**Revendications**

1. Dispositif pour la génération et la commande du flux d'agents de nettoyage, adaptable sur une chambre de procédés (1) pour assurer son nettoyage par un agent de nettoyage gazeux, comprenant un dispositif de recirculation (9) adapté pour prélever des gaz sortant de la chambre de procédés (1) et pour les filtrer et les réintroduire dans la chambre de procédés (1), **caractérisé en ce que** le dispositif de recirculation (9) est structuré de façon que, en toutes portions de son trajet dans le dispositif de recirculation (9), les gaz recyclés restent sensiblement à la pression basse régnant dans la chambre de procédé.

2. Dispositif selon la revendication 1, dans lequel les gaz recyclés restent à une pression inférieure à environ 20 Torr.

3. Dispositif selon l'une des revendications 1 et 2, comprenant :

   - une canalisation de recirculation (10) dans laquelle est insérée une pompe de recirculation (12) multiétagée,
   - une aspiration (12c) de pompe de recirculation (12) reliée à la chambre de procédé (1),
   - une sortie dérivée (12b) au refoulement du premier étage (12a) de la pompe (12), la sortie dérivée (12b) étant connectée à la canalisation de recirculation (10),
   - une canalisation de retour (15) connectée entre le refoulement (12d) du dernier étage de la pompe de recirculation (12) et la sortie dérivée (12b),
   - une canalisation de refoulement (16) raccordée entre le refoulement (12d) du dernier étage de la pompe de recirculation (12) et le refoulement du groupe de pompage principal (3) de la chambre de procédés (1).

4. Dispositif selon la revendication 3, comprenant des vannes tout ou rien (17, 18, 19, 20), pilotées par un dispositif de commande (21) pour isoler le dispositif de recirculation (9) par rapport à la chambre de procédés (1) pendant les étapes de régénération du piège (11).

5. Dispositif selon l'une des revendications précédentes, dans lequel le dispositif de recirculation (9) comprend une canalisation de recirculation (10) dans laquelle sont insérés une pompe de recirculation (12), un piège (11) pour retenir sélectivement les produits issus du nettoyage de la chambre de procédés (1), et un moyen de mesure de flux pour mesurer le flux gazeux de recirculation en aval du piège (11), dans lequel :

   - la pompe de recirculation (12) est entraînée par un moteur (25) à vitesse variable,
   - un contrôleur de commande (21) pilote la vitesse du moteur (25) d'entraînement de pompe de recirculation,
   - le moyen de mesure de flux comprend un second capteur de pression (14) adapté dans une zone de la canalisation de recirculation (10) en aval du piège (11), et un premier capteur de pression (7) adapté en aval du second capteur de pression (14) dans la canalisation de recirculation (10) ou dans la chambre de procédés (1),
   - un contrôleur de flux (21) reçoit les informations du premier (7) et du second (14) capteurs de pression et contient un programme enregistré et des données de comparaison enregistrées pour déterminer le flux de recirculation à partir desdites informations du premier et du second capteurs de recirculation (7, 14).

6. Dispositif selon la revendication 5, dans lequel le programme enregistré contient une séquence d'apprentissage par laquelle le contrôleur de flux (21) enregistre deux suites de mesures de pression réalisées respectivement par le premier capteur de pression (7) et par le second capteur de pression (14) pour une série de valeurs connues de flux de gaz parcourant le dispositif de recirculation (9).

7. Dispositif selon l'une des revendications 5 et 6, dans lequel le contrôleur de commande (21) pilote la vitesse du moteur (25) d'entraînement de la pompe de recirculation (12) de façon à établir un flux de recirculation selon une courbe de valeurs de flux prédéterminées.

8. Dispositif selon la revendication 7, dans lequel le contrôleur de commande (21) qui pilote la pompe de recirculation (12) est également le contrôleur de flux (21) du moyen de mesure de flux, lequel contrôleur combiné (21) reçoit une consigne évolutive en forme de courbe de valeurs de flux et pilote le moteur (25) de la pompe de recirculation (12) de façon que les valeurs mesurées de flux de recirculation suivent la consigne évolutive.

**9.** Dispositif selon la revendication 7, dans lequel le contrôleur de commande (21) qui pilote la pompe de recirculation (12) reçoit une consigne évolutive de flux de recirculation, qu'il traduit par un programme en termes de vitesse de la pompe de recirculation (12) pour piloter la vitesse du moteur (25) d'entraînement de la pompe de recirculation (12).

**10.** Dispositif selon la revendication 9, dans lequel le programme du contrôleur de commande (21) de pompe de recirculation (12) contient une séquence d'apprentissage qui commande la rotation du moteur (25) d'entraînement de pompe de recirculation (12) selon une suite de vitesses de rotation, et qui enregistre les valeurs mesurées du flux de recirculation correspondant provenant du contrôleur de flux (21) ou des capteurs de pression (7, 14), pour définir la relation entre la vitesse de rotation de la pompe de recirculation (12) et la valeur du flux de recirculation.

**11.** Dispositif selon la revendication 9, dans lequel le contrôleur de commande (21) de pompe de recirculation (12) contient une séquence de programme enregistrée qui détermine la valeur nécessaire du flux de recirculation pour maintenir constant le flux total d'agents de nettoyage dans la chambre de procédés (1) lorsque varie le flux d'agents de nettoyage injecté directement dans la chambre de procédés (1).

**12.** Dispositif selon l'une quelconque des revendications 5 à 11, dans lequel le piège (11) est un piège cryogénique disposé en amont de la pompe de recirculation (12).

**13.** Dispositif selon l'une quelconque des revendications 5 à 12, dans lequel le piège (11) est un piège cryogénique comportant une canalisation (11a) conductrice de la chaleur, ayant un tronçon amont (11 b) traversé par des ailettes (11c) conductrices de la chaleur, ayant un tronçon aval (11d) rempli de mailles (11e) en acier inoxydable au contact de la paroi de canalisation, la canalisation (11a) étant traversée par le flux de recirculation et étant baignée extérieurement dans de l'azote liquide (11 h).

**14.** Procédé de nettoyage par un agent de nettoyage gazeux d'une chambre de procédé associée à une source plasma au moyen d'un dispositif selon l'une des revendications précédentes, comprenant une étape d'utilisation de ladite chambre de procédé (1), une étape de nettoyage de ladite chambre de procédé (1), et une étape de régénération dudit dispositif, **caractérisé en ce que** ladite étape de régénération peut être effectuée simultanément à ladite étape d'utilisation.

**15.** Procédé selon la revendication 14, dans lequel ladite étape de régénération a lieu pendant chaque étape d'utilisation.

**16.** Procédé selon l'une des revendications 14 et 15, dans lequel, au cours de l'étape de nettoyage, une partie minoritaire des gaz recyclés remonte tous les étage de la pompe (12), sort par la canalisation de retour (15) et rejoint la sortie dérivée (12b), et la majorité des gaz recyclés passe directement par la sortie dérivée (12b).

**17.** Procédé selon l'une des revendications 14 à 15, dans lequel, au cours de l'étape de régénération, la vanne (20) est ouverte et la pompe (12) vide le système de recirculation (9) en extrayant les produits issus du nettoyage condensés sur le piège cryogénique (11) et en les refoulant dans la canalisation (16).

**FIG. 1**

11

11h

11a

11i

11e

11c

11d

11b

11f

11g

FIG. 2

**Office européen des brevets**

# RAPPORT DE RECHERCHE EUROPEENNE

Numéro de la demande

EP 04 29 2907

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | US 2003/036272 A1 (LAI CANFENG ET AL) 20 février 2003 (2003-02-20) * figures 4,7 * * alinéas [0031], [0100] - [0108] * ----- | 1-4 | C23C16/44 H01L21/00 |
| A | EP 1 243 667 A (EBARA CORP ; TOKYO SHIBAURA ELECTRIC CO (JP)) 25 septembre 2002 (2002-09-25) * le document en entier * ----- | 1-17 | |
| A | PATENT ABSTRACTS OF JAPAN vol. 2003, no. 05, 12 mai 2003 (2003-05-12) & JP 2003 017416 A (TOKYO ELECTRON LTD), 17 janvier 2003 (2003-01-17) * abrégé * ----- | 1-17 | |
| A | EP 1 164 628 A (APPLIED MATERIALS INC) 19 décembre 2001 (2001-12-19) * alinéas [0017], [0018]; figure 1 * ----- | 1,2 | |
| A | PATENT ABSTRACTS OF JAPAN vol. 1998, no. 01, 30 janvier 1998 (1998-01-30) & JP 09 251981 A (TOSHIBA CORP), 22 septembre 1997 (1997-09-22) * abrégé * ----- | 1,2 | DOMAINES TECHNIQUES RECHERCHES (Int.Cl.7) |
| A | US 2002/034880 A1 (OHIWA TOKUHISA ET AL) 21 mars 2002 (2002-03-21) * le document en entier * ----- | 1-17 | C23C |
| A | PATENT ABSTRACTS OF JAPAN vol. 2002, no. 05, 3 mai 2002 (2002-05-03) & JP 2002 033315 A (SEIKO EPSON CORP), 31 janvier 2002 (2002-01-31) * abrégé * | 1-17 | |

-/--

Le présent rapport a été établi pour toutes les revendications

| Lieu de la recherche | Date d'achèvement de la recherche | Examinateur |
|---|---|---|
| La Haye | 17 mars 2005 | Castagné, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

EP 1 541 709 A1

**Office européen des brevets**

## RAPPORT DE RECHERCHE EUROPEENNE

Numéro de la demande

EP 04 29 2907

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| P,A | & EP 1 371 750 A (BOC GROUP INC) 17 décembre 2003 (2003-12-17) * le document en entier * ----- | 1-17 | |
| | | | **DOMAINES TECHNIQUES RECHERCHES (Int.Cl.7)** |

Le présent rapport a été établi pour toutes les revendications

| Lieu de la recherche | Date d'achèvement de la recherche | Examinateur |
|---|---|---|
| La Haye | 17 mars 2005 | Castagné, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 04 29 2907

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

17-03-2005

| Document brevet cité au rapport de recherche | | Date de publication | Membre(s) de la famille de brevet(s) | | Date de publication |
|---|---|---|---|---|---|
| US 2003036272 | A1 | 20-02-2003 | WO<br>EP<br>JP<br>TW | 03101635 A1<br>1164628 A2<br>2002075973 A<br>516076 B | 11-12-2003<br>19-12-2001<br>15-03-2002<br>01-01-2003 |
| EP 1243667 | A | 25-09-2002 | JP<br>EP<br>TW<br>US | 2002273198 A<br>1243667 A2<br>533504 B<br>2002134439 A1 | 24-09-2002<br>25-09-2002<br>21-05-2003<br>26-09-2002 |
| JP 2003017416 | A | 17-01-2003 | WO | 03005427 A1 | 16-01-2003 |
| EP 1164628 | A | 19-12-2001 | EP<br>JP<br>TW<br>US | 1164628 A2<br>2002075973 A<br>516076 B<br>2003036272 A1 | 19-12-2001<br>15-03-2002<br>01-01-2003<br>20-02-2003 |
| JP 09251981 | A | 22-09-1997 | AUCUN | | |
| US 2002034880 | A1 | 21-03-2002 | JP<br>JP | 2002100608 A<br>2002217166 A | 05-04-2002<br>02-08-2002 |
| JP 2002033315 | A | 31-01-2002 | AUCUN | | |
| EP 1371750 | A | 17-12-2003 | US<br>EP<br>JP | 2003228989 A1<br>1371750 A1<br>2004010478 A | 11-12-2003<br>17-12-2003<br>15-01-2004 |

EPO FORM P0460

Pour tout renseignement concernant cette annexe : voir Journal Officiel de l'Office européen des brevets, No.12/82